(19) Europäisches Patentamt
European Patent Office
Office européen des brevets

(11) **EP 4 243 099 A1**

(12) **EUROPEAN PATENT APPLICATION**
published in accordance with Art. 153(4) EPC

(43) Date of publication:
**13.09.2023 Bulletin 2023/37**

(21) Application number: **20963100.1**

(22) Date of filing: **30.11.2020**

(51) International Patent Classification (IPC):
**H01L 43/08** (2006.01)     **H01L 43/02** (2006.01)

(52) Cooperative Patent Classification (CPC):
**H10N 50/10; H10N 50/80**

(86) International application number:
**PCT/CN2020/132932**

(87) International publication number:
**WO 2022/110212 (02.06.2022 Gazette 2022/22)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **Huawei Technologies Co., Ltd.
Shenzhen, Guangdong 518129 (CN)**

(72) Inventors:
• **QIN, Qing
  Shenzhen, Guangdong 518129 (CN)**
• **ZHOU, Xue
  Shenzhen, Guangdong 518129 (CN)**
• **LIU, Xi
  Shenzhen, Guangdong 518129 (CN)**

(74) Representative: **Gill Jennings & Every LLP
The Broadgate Tower
20 Primrose Street
London EC2A 2ES (GB)**

(54) **MEMORY AND ELECTRONIC DEVICE**

(57)     Embodiments of this application provide a memory and an electronic device, and relate to the field of memory technologies, to increase a reversal speed of a free layer. The memory includes a plurality of memory cells and bit lines that are disposed in a storage region of the memory and that are distributed in an array. The memory cell includes a transistor and a magnetic tunnel junction MTJ element connected to the transistor. The MTJ element is disposed on a current transmission path between a source or a drain of the transistor and the bit line. The MTJ element includes a pinning layer, a reference layer, a tunneling layer, and a free layer that are sequentially stacked. A magnetization direction of the pinning layer is parallel to a stacking direction of layers in the MTJ. The memory further includes a first magnetic structure disposed on the current transmission path. A direction of a magnetic field generated by the first magnetic structure at the free layer is not parallel to a magnetization direction of the free layer.

FIG. 4a

## Description

### TECHNICAL FIELD

This application relates to the field of memory technologies, and in particular, to a memory and an electronic device.

### BACKGROUND

A magnetic random access memory (magnetic random access memory, MRAM) is a new type of nonvolatile memory. A spin transfer torque magnetic random access memory (spin transfer torque magnetic random access memory, STT MRAM) has received wide attention because of advantages such as a fast speed, low power consumption, and good compatibility of a COMS (complementary metal-oxide-semiconductor, complementary metal-oxide-semiconductor).

Read/write functions of the spin-transfer torque magnetic random access memory are implemented by a memory cell of the spin-transfer torque magnetic random access memory. A main structure of the memory cell includes a magnetic tunnel junction (magnetic tunnel junction, MTJ) element and a transistor. A structure of an MTJ is mainly formed by sequentially stacking a free layer storing information, a tunneling layer, a reference layer with a fixed magnetization direction, and a pinning layer. The magnetization direction of the reference layer is pinned by the pinning layer in a specific direction, and a magnetization direction of the free layer may change. When a current flows through the MTJ from different directions (where the current flows from a fixed layer to the free layer or the current flows from the free layer to the fixed layer), the magnetization direction of the free layer changes accordingly. When the magnetization direction of the free layer is parallel to the magnetization direction of the reference layer, in other words, when the magnetization direction of the free layer is the same as the magnetization direction of the reference layer, the memory cell presents a low resistance, and may store "0". When the magnetization direction of the free layer is anti-parallel to the magnetization direction of the reference layer, in other words, when the magnetization direction of the free layer is opposite to the magnetization direction of the reference layer, the memory cell presents a high resistance, and may store "1". Reading of the magnetic random access memory is to detect a resistance of the memory cell. A constant small current flows through the MTJ from a bit line, and a potential difference is generated at two ends of the MTJ. A resistance of the MTJ may be determined based on the potential difference, and then whether information stored in the magnetic random access memory is "0" or "1" may be determined.

Currently, when data is written into the memory cell, a reversal speed of the free layer is low, and therefore, write efficiency of the memory cell is affected.

## SUMMARY

Embodiments of this application provide a memory and an electronic device, to increase a reversal speed of a free layer.

To achieve the foregoing objective, this application uses the following technical solutions.

According to a first aspect, a memory is provided. The memory includes a plurality of memory cells and bit lines that are disposed in a storage region of the memory and that are distributed in an array. The memory cell includes a transistor and a magnetic tunnel junction MTJ element connected to the transistor. The MTJ element is disposed on a current transmission path between a source or a drain of the transistor and the bit line. The MTJ element includes a pinning layer, a reference layer, a tunneling layer, and a free layer that are sequentially stacked. A magnetization direction of the pinning layer is parallel to a stacking direction of layers in an MTJ. The memory further includes a first magnetic structure disposed on the current transmission path. A direction of a magnetic field generated by the first magnetic structure at the free layer is not parallel to a magnetization direction of the free layer. Because the direction of the magnetic field generated by the first magnetic structure at the free layer is not parallel to the magnetization direction of the free layer, the magnetic field generated by the first magnetic structure at the free layer may apply a magnetic field force to the free layer, which facilitates reversal of the free layer. In this way, a current required for the reversal of the free layer is reduced, incubation time of an STT is shortened, a reversal speed of the free layer is increased, write time is shortened, and write efficiency is improved.

In a possible implementation, the direction of the magnetic field generated by the first magnetic structure at the free layer is perpendicular to the magnetization direction of the free layer. In this way, the magnetic field generated by the first magnetic structure at the free layer is larger, which further facilitates the reversal of the free layer. Therefore, the incubation time of the STT can be further shortened, and the reversal speed of the free layer can be more effectively increased.

In a possible implementation, the memory further includes a connection layer disposed between the first magnetic structure and the MTJ element. The first magnetic structure is electrically connected to the MTJ element through the connection layer. A projection of the MTJ element on the connection layer and a projection of the first magnetic structure on the connection layer do not overlap in at least a partial region. The direction of the magnetic field generated by the first magnetic structure at the free layer may be adjusted by adjusting a magnetization direction of the first magnetic structure and relative positions of the MTJ element and the first magnetic structure in a direction perpendicular to the stacking direction of the layers in the MTJ, so that the direction of the magnetic field generated by the first magnetic structure at the free layer is not parallel to the magnetization direction of the free layer.

In a possible implementation, the first magnetic structure is connected between the MTJ element and the source or the drain of the transistor.

In a possible implementation, the first magnetic structure is connected between the MTJ element and the bit line.

In a possible implementation, the MTJ element further includes a first electrode and a second electrode. The first electrode is located on a side of the free layer away from the pinning layer, and the second electrode is located on a side of the pinning layer away from the free layer. The first electrode is electrically connected to the bit line, and the second electrode is electrically connected to the source or the drain of the transistor. Alternatively, the first electrode is electrically connected to the source or the drain of the transistor, and the second electrode is electrically connected to the bit line. Herein, a magnitude of a voltage applied to the first electrode and the second electrode determines a flow direction of a current in the MTJ element.

In a possible implementation, a material of the first magnetic structure includes one or more of a cobalt monomer, an iron monomer, a nickel monomer, and an alloy including at least one of cobalt, iron, and nickel.

In a possible implementation, the pinning layer includes a first pinning sub-layer, a non-magnetic layer, and a second pinning sub-layer that are sequentially stacked, and a magnetization direction of the first pinning sub-layer is opposite to a magnetization direction of the second pinning sub-layer. Because the pinning layer includes the first pinning sub-layer and the second pinning sub-layer, and the magnetization direction of the first pinning sub-layer is opposite to the magnetization direction of the second pinning sub-layer, a direction of a stray field generated by the first pinning sub-layer at the free layer is opposite to a direction of a stray field generated by the second pinning sub-layer at the free layer. Therefore, the stray field generated by the first pinning sub-layer at the free layer and the stray field generated by the second pinning sub-layer at the free layer can be offset, so that impact of a stray field generated by the pinning layer at the free layer on the reversal of the free layer can be reduced or eliminated, and the current required for the reversal of the free layer is further reduced.

In a possible implementation, both the first pinning sub-layer and the second pinning sub-layer include a ferromagnetic layer and a heavy metal layer that are alternately stacked along the stacking direction of the layers in the MTJ.

In a possible implementation, a material of the ferromagnetic layer includes one or more of a cobalt monomer, an iron monomer, a nickel monomer, and an alloy including at least one of cobalt, iron, and nickel, and a material of the heavy metal layer includes one or more of a platinum monomer, a tantalum monomer, a copper monomer, an iridium monomer, a ruthenium monomer, a tungsten monomer, and an alloy including at least one of platinum, tantalum, copper, iridium, ruthenium, and tungsten.

In a possible implementation, the memory further includes a second magnetic structure that is disposed on the current transmission path and that is in contact with the MTJ element. An included angle between a magnetization direction of the second magnetic structure and the magnetization direction of the pinning layer is (90°, 180°]. The first magnetic structure is connected between the MTJ element and the source or the drain of the transistor, and the second magnetic structure is connected between the MTJ element and the bit line. Alternatively, the first magnetic structure is connected between the MTJ element and the bit line, and the second magnetic structure is connected between the MTJ element and the source or the drain of the transistor. Because the included angle between the magnetization direction of the second magnetic structure and the magnetization direction of the pinning layer is (90°, 180°], a magnetic field generated by the second magnetic structure at the free layer can offset a magnetic field generated by the pinning layer at the free layer, so that a compensation field generated by the free layer can be reduced or eliminated. In this way, the current required for the reversal the free layer is reduced, and a problem of MTJ reversal asymmetry (to be specific, values of currents required when the magnetization direction of the free layer changes to two opposite directions are different) can be resolved.

In a possible implementation, the magnetization direction of the second magnetic structure is opposite to the magnetization direction of the pinning layer, and a magnetic field generated by the second magnetic structure at the free layer is the same as a magnetic field generated by the pinning layer at the free layer. In this way, the magnetic field generated by the second magnetic structure at the free layer can offset the magnetic field generated by the pinning layer at the free layer. Therefore, a magnetic field received by the free layer is zero or approaches zero, and the compensation field generated by the free layer due to the magnetic field is zero or approaches zero. In this way, the current required for the reversal of the free layer is further reduced, and the problem of MTJ reversal asymmetry is more effectively resolved.

In a possible implementation, the magnetization direction of the second magnetic structure is opposite to the magnetization direction of the pinning layer, and a magnetic field generated by the second magnetic structure at the free layer is the same as magnetic fields generated by the pinning layer and the reference layer at the free layer. In this way, the magnetic fields generated by the pinning layer and the reference layer at the free layer can be offset by the magnetic field generated by the second magnetic structure at the free layer, so that the current required for the reversal of the free layer is further reduced.

In a possible implementation, the pinning layer includes a ferromagnetic layer and a heavy metal layer that are alternately stacked along the stacking direction of the layers in the MTJ. Because the pinning layer includes only the ferromagnetic layer and the heavy metal layer that are alternately stacked along the stacking direction of the layers in the MTJ, a thickness of the pinning layer is greatly reduced, and a structure is simplified. This helps reduce roughness of an interface between the tunneling layer and the free layer, reduce stress accumulation, and facilitate MTJ microshrinkage. In addition, the thickness of the pinning layer is greatly reduced, to be specific, a thickness of a conductive material under the tunneling layer is reduced, so that a probability of short circuit caused by resputtering during etching is reduced, and an engineering yield is increased.

In a possible implementation, a material of the pinning layer is a perpendicular magnetic anisotropy material. Because the material of the pinning layer is the perpendicular magnetic anisotropy material, the magnetization direction of the pinning layer is easily magnetized to be parallel to the stacking direction of the layers in the MTJ. Therefore, the thickness of the pinning layer may be set to be small. In this way, the structure is simplified. This helps reduce the roughness of the interface between the tunneling layer and the free layer, reduce the stress accumulation, and facilitate the MTJ microshrinkage. In addition, the thickness of the pinning layer is greatly reduced, to be specific, the thickness of the conductive material under the tunneling layer is reduced, so that the probability of short circuit caused by resputtering during etching is reduced, and the engineering yield is increased.

In a possible implementation, the material of the pinning layer includes one or more of an iron-platinum alloy and a cobalt-platinum alloy. Herein, the iron-platinum alloy and the cobalt-platinum alloy are all perpendicular magnetic anisotropy materials.

In a possible implementation, materials of the reference layer and the free layer include a cobalt-iron-boron CoFeB alloy, and a material of the tunneling layer includes magnesium oxide MgO.

In a possible implementation, a gate of the transistor is connected to a word line control circuit by using a word line WL, the source or the drain of the transistor is connected to a data line, and a bit line BL is connected to a bit line control circuit.

According to a second aspect, an electronic device is provided. The electronic device includes a circuit board and a memory electrically connected to the circuit board, and the memory is the foregoing memory. The electronic device has a same technical effect as that in the foregoing embodiments. Details are not described herein again.

**BRIEF DESCRIPTION OF DRAWINGS**

FIG. 1a is a schematic diagram of a structure of a storage system according to an embodiment of this application;

FIG. 1b is a schematic diagram of a structure of a storage system according to another embodiment of this application;

FIG. 1c is a schematic diagram of a structure of a storage system according to still another embodiment of this application;

FIG. 2 is a schematic diagram of a structure of a memory according to an embodiment of this application;

FIG. 3a is a schematic diagram of a structure of an MTJ element according to an embodiment of this application;

FIG. 3b is a schematic diagram of a structure of an MTJ element according to another embodiment of this application;

FIG. 4a is a schematic diagram of a structure of a memory according to another embodiment of this application;

FIG. 4b is a schematic diagram of structures of an MTJ element, a conductive structure, and a first magnetic structure according to an embodiment of this application;

FIG. 5a is a schematic diagram of a structure of a memory according to still another embodiment of this application;

FIG. 5b is a schematic diagram of structures of an MTJ element, a conductive structure, and a first magnetic structure according to another embodiment of this application;

FIG. 6a is a schematic diagram of a structure of a memory according to still yet another embodiment of this application;

FIG. 6b is a schematic diagram of structures of an MTJ element and a first magnetic structure according to an embodiment of this application;

FIG. 7a is a schematic diagram of a structure of a memory according to another embodiment of this application;

FIG. 7b is a schematic diagram of structures of an MTJ element, a conductive structure, and a first magnetic structure according to still another embodiment of this application;

FIG. 8a is a schematic diagram of a direction of a magnetic field in a first magnetic structure or a second magnetic structure and a direction of an external magnetic field according to an embodiment of this application;

FIG. 8b is a simulation result diagram of a plane of a position marked by using a black straight line B in FIG. 8a;

FIG. 9 is a schematic diagram of a structure of an MTJ element;

FIG. 10 is a schematic diagram of a structure of a first pinning sub-layer, a second pinning sub-layer, or a pinning layer in an MTJ element;

FIG. 11a is a schematic diagram of a structure of a memory according to still another embodiment of this application;

FIG. 11b is a schematic diagram of structures of an MTJ element, a first magnetic structure, and a second magnetic structure according to an embodiment of this application;

FIG. 12a is a schematic diagram of a structure of a memory according to still yet another embodiment of this application;

FIG. 12b is a schematic diagram of structures of an MTJ element, a first magnetic structure, and a second magnetic structure according to another embodiment of this application; and

FIG. 13 is a simulation result diagram of positions marked by using a black straight line A and a black straight line B in FIG. 8a.

Reference numerals:

10-Memory; 11-Memory cell; 12-MTJ element; 13-Substrate; 15-Conductive layer; 16-First magnetic structure; 17-Second magnetic structure; 18-Connection layer; 121-First electrode; 122-Second electrode; 141-Source; 142-Drain; 143-Active layer; 144-Gate; 151-First conductive part; 152-Second conductive part; 1231-Pinning layer; 1232-Reference layer; 1233-Tunneling layer; 1234-Free layer; 1235-Seed layer; 1236-Structure conversion layer; and 1237-Capping layer.

## DESCRIPTION OF EMBODIMENTS

The following describes the technical solutions in embodiments of this application with reference to the accompanying drawings in embodiments of this application. It is clear that the described embodiments are merely a part rather than all of embodiments of this application.

Unless defined otherwise, all technical and scientific terms used in this specification have the same meaning as commonly understood by a person of ordinary skill in the art.

The following terms "first", "second" and the like are merely intended for ease of description, and shall not be understood as an indication or implication of relative importance or implicit indication of a quantity of indicated technical features. Therefore, a feature limited by "first ", "second" and the like may explicitly indicate or implicitly include one or more such features. In addition, the term "electrical connection" may be a direct electrical connection, or may be an indirect electrical connection through an intermediate medium.

It should be noted that, in this application, words "example" or "for example" are used to represent giving an example, an illustration, or a description. Any embodiment or design scheme described as an "example" or "for example" in this application should not be explained as being more preferred or having more advantages than another embodiment or design scheme. Exactly, use of the word such as "example" or "for example" is intended to present a relative concept in a specific manner.

The technical solutions provided in this application may be applied to various storage systems that use a magnetic random access memory. For example, the technical solutions provided in this application are applied to a computer. For another example, the technical solutions provided in this application are applied to a storage system including a memory or a processor and a memory. The processor may be a central processing unit (central processing unit, CPU), an artificial intelligence (artificial intelligence, AI) processor, a digital signal processor (digital signal processor), a neural network processor, or the like.

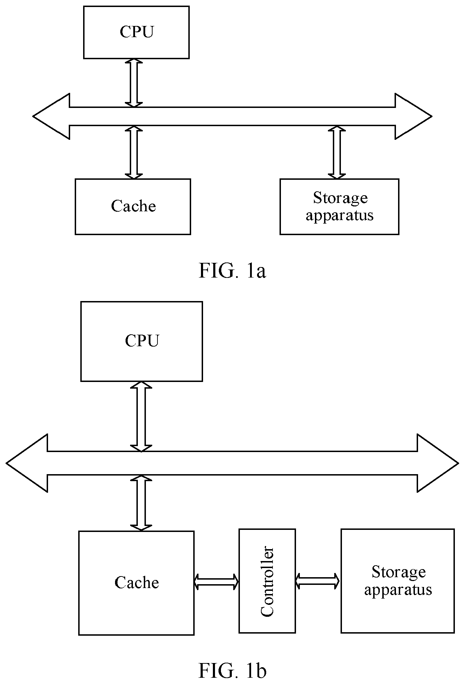

FIG. 1a is a schematic diagram of a structure of a storage system according to an embodiment of this application. The storage system may include a storage apparatus, and the storage apparatus may be a magnetic random access memory. Optionally, the storage system may further include a CPU, a cache (cache), a controller, and the like.

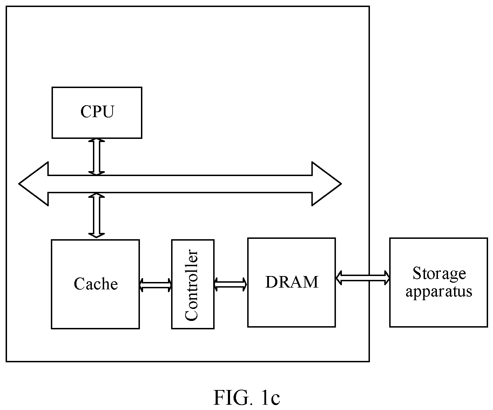

In an embodiment, as shown in FIG. 1a, the storage system includes a CPU, a cache, and a storage apparatus that are integrated together. In another embodiment, as shown in FIG. 1b, a storage system may be used as an independent memory. The storage system includes a CPU, a cache, a controller, and a storage apparatus that are integrated together. The storage apparatus is coupled to the cache and the CPU through the controller. In still another embodiment, as shown in FIG. 1c, a storage system includes a storage apparatus, and a CPU, a cache, a controller, and a dynamic random access memory (dynamic random access memory, DRAM) that are integrated together. The storage apparatus may be coupled to the DRAM as an external storage apparatus. The DRAM is coupled to the cache and the CPU through the controller. CPUs in various storage systems shown in FIG. 1a, FIG. 1b, and FIG. 1c may alternatively be replaced with CPU cores (cores). The storage apparatuses in FIG. 1a, FIG. 1b, and FIG. 1c may be magnetic random access memories.

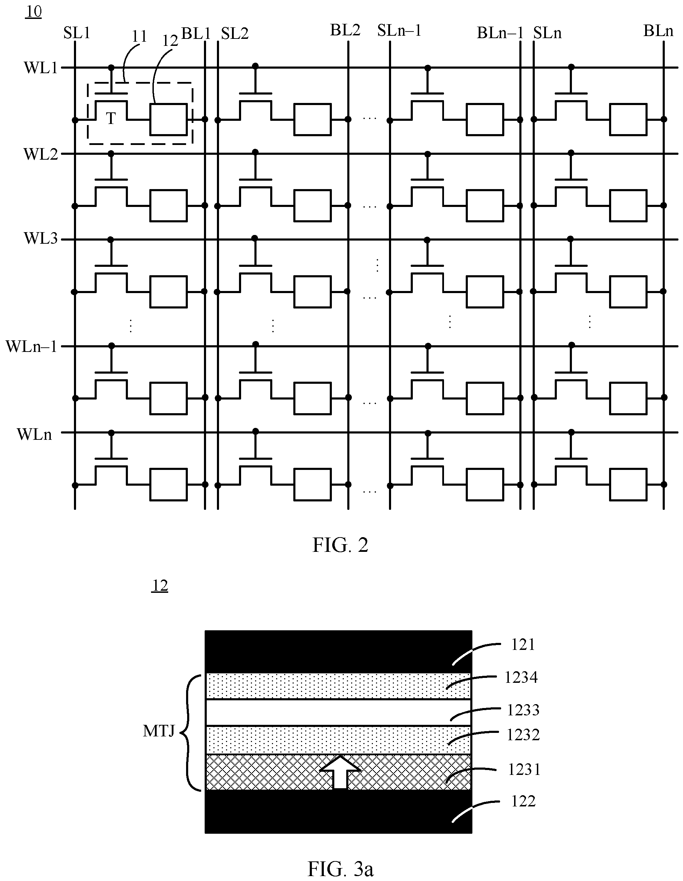

An embodiment of this application provides a magnetic random access memory (referred to as a memory below), which may be applied to the foregoing storage system. As shown in FIG. 2, a structure of the memory 10 includes a plurality of memory cells 11 that are disposed in a storage region of the memory 10 and that are distributed in an array. The memory cell 11 includes a transistor T and a magnetic tunnel junction MTJ element 12 connected to the transistor T.

The transistor T may be a thin film transistor (thin film transistor, TFT), or may be another type of transistor such as a MOS (metal oxide semiconductor) transistor. The transistor T includes a source, a drain, an active layer, a gate insulation layer, and a gate. Both the source and the drain are in contact with the active layer, and the gate insulation layer is disposed between the gate and the active layer.

As shown in FIG. 2, the structure of the memory 10 further includes a plurality of word lines (word lines, WLs) arranged in parallel and a plurality of bit lines (bit lines, BLs) arranged in parallel, and the word line WL and the bit line BL intersect each other. For example, the word line WL and the bit line BL are perpendicular to each other. In some embodiments, the memory 10 further includes a plurality of data lines arranged in parallel, and the data line may be parallel to the bit line BL. The gate of the transistor T is electrically connected to the word line WL, and the source or the drain of the transistor T is electrically connected to the data line. Herein, the source of the transistor T may be electrically connected to the data line. In this case, the data line may also be referred to as a source line (source line, SL). Alternatively, the drain of the transistor T may be electrically connected to the data line. In FIG. 2, an example in which the source of the transistor T is electrically connected to the source line is used for illustration.

In some embodiments, the word line WL is further electrically connected to a word line control circuit, and a high-level signal or a low-level signal is provided for the word line WL through the word line control circuit, so that the transistor T is in an on state or a cut-off state. When the transistor T is an N-type transistor, a high-level signal controls the transistor T to be on, and a low-level signal controls the transistor T to be cut off. When the transistor T is a P-type transistor, a low-level signal controls the transistor T to be on, and a high-level signal controls the transistor T to be cut off.

In some embodiments, the bit line BL is further electrically connected to a bit line control circuit, and a signal is provided for the bit line BL through the bit line control circuit.

In some embodiments, the data line is grounded.

The MTJ element 12 is disposed on a current transmission path between the source or the drain of the transistor T and the bit line BL.

As shown in FIG. 3a, the MTJ element 12 includes a first electrode 121, a second electrode 122, and an MTJ located between the first electrode 121 and the second electrode 122. The MTJ includes a pinning layer 1231, a reference layer 1232, a tunneling layer 1233, and a free layer 1234 that are sequentially stacked. A magnetization direction (which may also be referred to as a magnetic moment direction) of the pinning layer 1231 is parallel to a stacking direction of layers in the MTJ. The first electrode 121 is located on a side of the free layer 1234 away from the pinning layer 1231, and the second electrode 122 is located on a side of the pinning layer 1231 away from the free layer 1234. The first electrode 121 in the MTJ element 12 is electrically connected to the bit line BL, and the second electrode 122 is electrically connected to the drain or the source of the transistor T. Alternatively, the first electrode 121 is electrically connected to the drain or the source of the transistor T, and the second electrode 122 is electrically connected to the bit line BL. An example in which the first electrode 121 is electrically connected to the bit line BL, the second electrode 122 is electrically connected to the drain of the transistor T, and the source of the transistor T is electrically connected to the source line SL is used below for description.

It should be understood that when the second electrode 122 or the first electrode 121 is electrically connected to the drain of the transistor T, the source of the transistor T is electrically connected to the data line. When the second electrode 122 or the first electrode 121 is electrically connected to the source of the transistor T, the drain of the transistor is electrically connected to the data line.

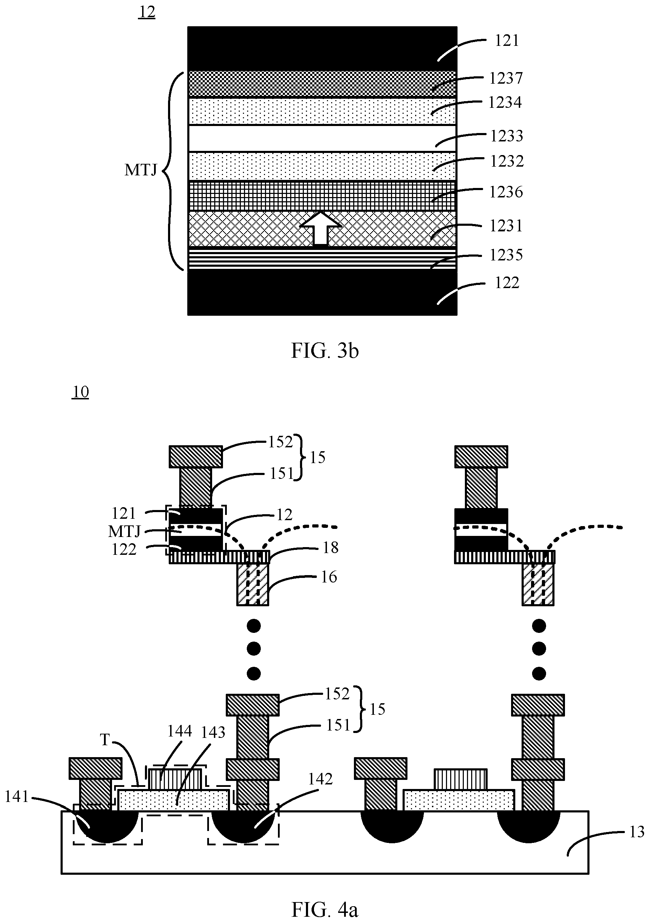

It should be noted that the stacking direction of the layers in the MTJ may be directed from the pinning layer 1231 to the free layer 1234, or may be directed from the free layer 1234 to the pinning layer 1231. An arrow marked in the pinning layer 1231 in each of FIG. 3a and FIG. 3b is the magnetization direction of the pinning layer 1231. For example, the stacking direction of the layers in the MTJ is a direction from the pinning layer 1231 to the free layer 1234. In this case, the arrow marked in the pinning layer 1231 in each of FIG. 3a and FIG. 3b may also represent the stacking direction of the layers in the MTJ. For example, the stacking direction of the layers in the MTJ is the direction from the pinning layer 1231 to the free layer 1234. That the magnetization direction of the pinning layer 1231 is parallel to the stacking direction of the layers in the MTJ may be that the magnetization direction of the pinning layer 1231 is the same as the stacking direction of the layers in the MTJ. That is, the magnetization direction of the pinning layer 1231 is the direction from the pinning layer 1231 to the free layer 1234. Alternatively, the magnetization direction of the pinning layer 1231 may be parallel to and opposite to the stacking direction of the layers in the MTJ. In other words, the magnetization direction of the pinning layer 1231 is a direction from the free layer 1234 to the pinning layer 1231.

In addition, the reference layer 1232 is a film layer that has a fixed magnetization direction in the MTJ. There is a strong ferromagnetic coupling effect between the pinning layer 1231 and the reference layer (which may also be referred to as a pinned layer) 1232. A magnetization direction of the reference layer 1232 may be pinned by the pinning layer 1231 in a fixed direction, and the magnetization direction of the reference layer 1232 is difficult to be changed. The magnetization direction of the reference layer 1232 is the same as the magnetization direction of the pinning layer 1231. Therefore, the magnetization direction of the reference layer 1232 is also parallel to the stacking direction of the layers in the MTJ. In addition, the pinning layer 1231 is configured to pin the magnetization direction of the reference layer 1232 in the fixed direction. Therefore, the magnetization direction of the pinning layer 1231 should not be easily changed. That is, the pinning layer 1231 should have a large coercive field. However, the reference layer 1232 and the free layer 1234 are in a decoupled state due to a function of the tunneling layer 1233. Therefore, a magnetization direction of the free layer 1234 is easily changed under an action of an external magnetic field. The magnetization direction of the free layer 1234 may be parallel to or anti-parallel to the magnetization direction of the reference layer 1232. In other words, the magnetization direction of the free layer 1234 may be the same as or opposite to the magnetization direction of the reference layer 1232.

Based on the foregoing descriptions, because magnetization directions of the pinning layer 1231, the reference layer 1232, and the free layer 1234 are all parallel to the stacking direction of the layers in the MTJ, the MTJ in this embodiment of this application is an MTJ with perpendicular magnetic anisotropy (perpendicular magnetic anisotropy, PMA).

The reference layer 1232 and the free layer 1234 are magnetic layers. For example, materials of the reference layer 1232 and the free layer 1234 include one or more of a cobalt-iron-boron (CoFeB) alloy, a cobalt-iron (CoFe) alloy, or a nickel-iron-cobalt (NiFeCo) alloy. For example, the materials of the reference layer 1232 and the free layer 1234 are CoFeB alloys. Specifically, the materials of the reference layer 1232 and the free layer 1234 may be $(Co_xFe_{1-x})_{1-y}B_y$, where both x and y range from 0 to 0.30.

The tunneling layer 1233 is a non-magnetic layer. For example, a material of the tunneling layer 1233 includes one or more of magnesium oxide (MgO) or aluminum dioxide ($Al_2O_3$).

To facilitate growth of the pinning layer 1231, in some embodiments, as shown in FIG. 3b, the MTJ element 12 further includes a seed (seed) layer 1235 disposed between the second electrode 122 and the pinning layer 1231, and the pinning layer 1231 may be grown on the seed layer 1235.

It is considered that a material of the reference layer 1232 is generally in a crystal orientation of 001, and a material of the pinning layer 1231 is generally in a crystal orientation of 111. Because a crystal lattice difference between the reference layer 1232 and the pinning layer 1231 is large, it is difficult to grow the reference layer 1232 on the pinning layer 1231, and roughness accumulation, stress accumulation, and the like are caused. Based on this, in some embodiments, as shown in FIG. 3b, the MTJ element 12 further includes a structure conversion layer 1236 disposed between the reference layer 1232 and the pinning layer 1231, and a material of the structure conversion layer 1236 is an amorphous material.

The material of the structure conversion layer 1236 disposed between the reference layer 1232 and the pinning layer 1231 is the amorphous material, and the amorphous material has no fixed crystal orientation. Therefore, growing the reference layer 1232 on the structure conversion layer 1236 can avoid a growth difficulty caused by the crystal lattice difference, and avoid problems such as the roughness accumulation and the stress accumulation.

For example, the material of the structure conversion layer 1236 is one or more of tantalum (Ta), a tantalum alloy, or a tantalum-tungsten alloy. The tantalum is an amorphous material.

On this basis, in some embodiments, as shown in FIG. 3b, the MTJ element 12 further includes a capping (capping) layer 1237 that is disposed on a side of the free layer 1234 away from the tunneling layer 1233 and that is in contact with the free layer 1234. Herein, after the capping layer 1237 is added, an interface between the capping layer 1237 and the free layer 1234 helps increase perpendicular magnetic anisotropy of the free layer 1234, so that data storage time can be increased.

For example, a material of the capping layer 1237 includes magnesium oxide.

It should be understood that the tunneling layer 1233 is located between the reference layer 1232 and the free layer 1234. When data stored in the MTJ element 12 is read, more than 90% of a tunneling magnetic resistance (tunneling magneto resistance, TMR) of the MTJ element 12 is from the tunneling layer 1233. Therefore, a resistance of the tunneling layer 1233 should be set to be large. Further, the capping layer 1237 is located on the side of the free layer 1234 away from the tunneling layer 1233. In this way, the capping layer 1237 is not only configured to increase the perpendicular magnetic anisotropy of the free layer 1234, but also configured to transmit a current. Therefore, a resistance of the capping layer 1237 should be set to be small. That is, the resistance of the tunneling layer 1233 is far greater than the resistance of the capping layer 1237. When both the material of the tunneling layer 1233 and the material of the capping layer 1237 are magnesium oxide, because the resistance of the tunneling layer 1233 is far greater than the resistance of the capping layer 1237, a thickness of the capping layer 1237 may be adjusted to be small, so that the resistance of the capping layer 1237 is small. Certainly, the magnesium oxide may be formed in a manner of magnesium oxidation growth, and a resistance of the formed magnesium oxide is small.

A key to implementing read/write of a magnetic random access memory is that the magnetic random access memory has a large tunneling magnetic resistance and has high spin transfer efficiency. The foregoing MTJ structure in this application can obtain the large tunneling magnetic resistance (150% to 250%) and has the high spin transfer efficiency (> 0.8). Therefore, a read/write function can be ensured.

Based on the structure of the memory 10 described above, the following uses one memory cell 11 as an example to describe a working process of the memory 10.

During writing into the memory cell 11, the transistor T is in the on state. When a direction of a current is flowing from the free layer 1234 to the reference layer 1232, in other words, spin electrons flow from the reference layer 1232 to the free layer 1234, and when the spin electrons pass through the reference layer 1232, the electrons in the current are spin-polarized along the magnetization direction of the reference layer 1232, and a spin magnetic moment of the electrons is parallel to the magnetization direction of the reference layer 1232. When the electrons pass through the tunneling layer 1233 and reach the free layer 1234, the spin electrons transfer a spin moment (also referred to as a spin angular momentum, that is, an STT) to the free layer 1234. Further, the free layer 1234 subject to a spin moment effect has a small magnetization intensity. Therefore, the magnetization direction of the free layer 1234 can freely change based on a polarization direction of the spin electrons in a spin current, so that the magnetization direction of the free layer 1234 is finally parallel to the magnetization direction of the reference layer 1232, in other words, the magnetization direction of the free layer 1234 is the same as the magnetization direction of the reference layer 1232, which may represent that written information is "0".

When the direction of the current is flowing from the reference layer 1232 to the free layer 1234, in other words, when the spin electrons flow from the free layer 1234 to the reference layer 1232, the spin electrons exchange coupling with a magnetic moment in the reference layer 1232, so that electrons whose spinning is parallel to the magnetization direction of the reference layer 1232 pass through, but electrons whose spinning is anti-parallel to the magnetization direction of the reference layer 1232 are reflected. The reflected electrons pass through the tunneling layer 1233 and reach the free layer 1234, and exchange coupling with a magnetic moment of the free layer 1234, so that the magnetization direction of the free layer 1234 rotates in an opposite direction of the magnetization direction of the reference layer 1232, and the magnetization direction of the free layer 1234 and the magnetization direction of the reference layer 1232 are finally in an anti-parallel state, that is, the magnetization direction of the free layer 1234 is opposite to the magnetization direction of the reference layer 1232, which may represent that the written information is "1". The direction of the current herein may be controlled by using voltages provided on the bit line BL and the source line SL. When a voltage provided on the bit line BL is greater than a voltage provided on the source line SL, the current flows from the free layer 1234 to the reference layer 1232. Alternatively, when the voltage provided on the bit line BL is less than the voltage provided on the source line SL, the current flows from the reference layer 1232 to the free layer 1234.

During reading from the memory cell 11, a constant small current flows from the bit line BL through the MTJ to the drain of the turned-on transistor T, and a potential difference is generated at two ends of the MTJ. Based on the potential difference, a resistance of the MTJ may be determined, to be specific, a relative orientation relationship between the magnetization direction of the free layer 1234 and the magnetization direction of the reference layer 1232 may be obtained, to determine whether information stored in the memory cell 11 is "0" or "1". Specifically, when the MTJ presents a low resistance, the magnetization direction of the free layer 1234 is parallel to the magnetization direction of the reference layer 1232, and the information stored in the memory cell 11 is "0". When the MTJ presents a high resistance, the magnetization direction of the free layer 1234 is anti-parallel to the magnetization direction of the reference layer 1232, and the information stored in the memory cell 11 is "1".

It should be understood that, when information is stored in and read from the memory 10, the word line control circuit provides a gating signal to the word lines row by row, so that transistors T in memory cells 11 in a plurality of rows are turned on row by row, and the information can be written or read row by row.

Based on a working principle of the memory cell 11 described above, the memory 10 according to this embodiment of this application may also be referred to as a spin transfer torque magnetic random access memory.

Refer to FIG. 4a, FIG. 5a, and FIG. 6a. The memory 10 may further include a substrate 13, a transistor T, an MTJ element 12, and another pattern that are all disposed on the substrate 13. In FIG. 4a, FIG. 5a, and FIG. 6a, an example in which the transistor is a MOS transistor is used for illustration. A source 141, a drain 142, an active layer 143, and a gate 144 of the transistor T are illustrated, and a gate insulation layer disposed between the gate 144 and the active layer 143 is not illustrated.

It should be understood that, in a manufacturing process of the memory 10, after the transistor T is manufactured on the substrate 13, the MTJ element 12 is not directly manufactured. Usually, after the transistor T is manufactured and before the MTJ element 12 is manufactured, another conductive function pattern and an insulation layer (where FIG. 4a, FIG. 5a, and FIG. 6a do not show the conductive function pattern and the insulation layer) are further formed. Based on this, to electrically connect the drain 142 of the transistor T to a second electrode 122 of the MTJ element 12, as shown in FIG. 4a, FIG. 5a, and FIG. 6a, on a current transmission path between the drain 142 of the transistor T and the MTJ element 12, at least one conductive structure 15 (which may also be referred to as a conductive tube or a metal conductive tube) is connected in series between the second electrode 122 and the drain 142 of the transistor T, and the second electrode 122 is electrically connected to the drain 142 of the transistor T through the at least one conductive structure 15. Similarly, after the MTJ element 12 is manufactured and before a bit line BL is manufactured, a conductive function pattern and an insulation layer are also formed. Based on this, to electrically connect a first electrode 121 to the bit line BL, as shown in FIG. 4a, FIG. 5a, and FIG. 6a, on a current transmission path between the MTJ element 12 and the bit line BL, at least one conductive structure 15 is connected in series between the first electrode 121 and the bit line BL, and the first electrode 121 is electrically connected to the bit line BL through the at least one conductive structure 15. The conductive structure 15 and the conductive function pattern may be synchronously formed.

On this basis, as shown in FIG. 4a, FIG. 5a, and FIG. 6a, the memory 10 according to this embodiment of this application further includes a first magnetic structure 16 disposed on the current transmission path. A direction of a magnetic field (where the magnetic field may be referred to as a magnetostatic field or a stray field) generated by the first magnetic structure 16 at a free layer 1234 is not parallel to a magnetization direction of the free layer 1234.

In comparison with a conventional technology, in this embodiment of this application, the first magnetic structure 16 is added to the current transmission path between the source 141 or the drain 142 of the transistor T and the bit line BL.

It should be understood that, because the first magnetic structure 16 is disposed on the current transmission path between the source 141 or the drain 142 of the transistor T and the bit line BL, the first magnetic structure 16 is conductive.

The following provides two implementations as examples, so that the direction of the magnetic field generated by the first magnetic structure 16 at the free layer 1234 is not parallel to the magnetization direction of the free layer 1234.

In a first implementation, as shown in FIG. 4a, FIG. 5a, and FIG. 6a, the memory further includes a connection layer 18 disposed between the first magnetic structure 16 and the MTJ element 12. The first magnetic structure 16 is electrically connected to the MTJ element 12 through the connection layer 18. A projection of the MTJ element 12 on the connection layer 18 and a projection of the first magnetic structure 16 on the connection layer 18 do not overlap in at least a partial region.

In this implementation, in some embodiments, a magnetization direction of the first magnetic structure 16 is parallel to a stacking direction of layers in the MTJ.

It should be noted that, to ensure that the magnetization direction of the first magnetic structure 16 can still remain unchanged after an external magnetic field is removed, for example, the magnetization direction of the first magnetic structure 16 is parallel to the stacking direction of the layers in the MTJ, that is, to enable the first magnetic structure 16 to have magnetic shape anisotropy, a length of the first magnetic structure 16 along a direction parallel to the stacking direction of the layers in the MTJ is greater than or equal to a length of the first magnetic structure 16 along a direction perpendicular to the stacking direction of the layers in the MTJ. When the first magnetic structure 16 is a cylinder, a height of the first magnetic structure 16 is greater than or equal to a diameter of the first magnetic structure 16.

On this basis, the direction of the magnetic field generated by the first magnetic structure 16 at the free layer 1234 may be adjusted by adjusting the magnetization direction of the first magnetic structure 16 and relative positions of the MTJ element 12 and the first magnetic structure 16 in the direction perpendicular to the stacking direction of the layers in the MTJ.

In addition, in some examples, the projection of the MTJ element 12 on the connection layer 18 and the projection of the first magnetic structure 16 on the connection layer 18 overlap in a partial region, and do not overlap in a partial region. In some other examples, the projection of the MTJ element 12 on the connection layer 18 and the projection of the first magnetic structure 16 on the connection layer 18 do not overlap, that is, there is no overlapping region between the projection of the MTJ element 12 on the connection layer 18 and the projection of the first magnetic structure 16 on the connection layer 18. In the accompanying drawings of embodiments of this application, an example in which there is no overlapping region between the projection of the MTJ element 12 on the connection layer 18 and the projection of the first magnetic structure 16 on the connection layer 18 is used for illustration.

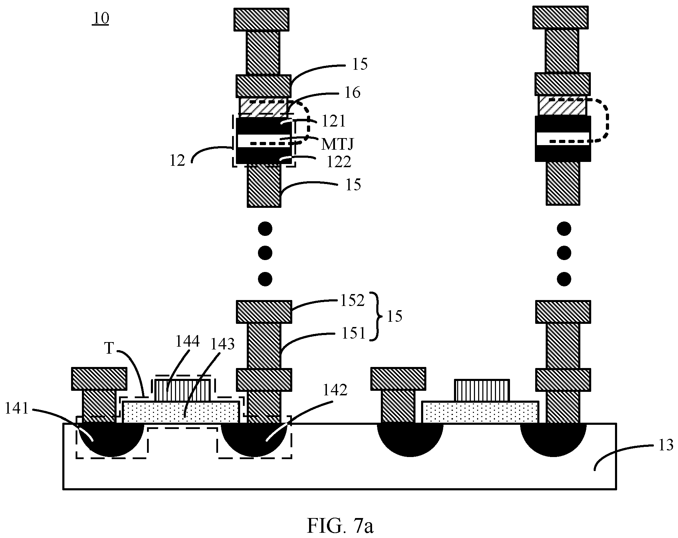

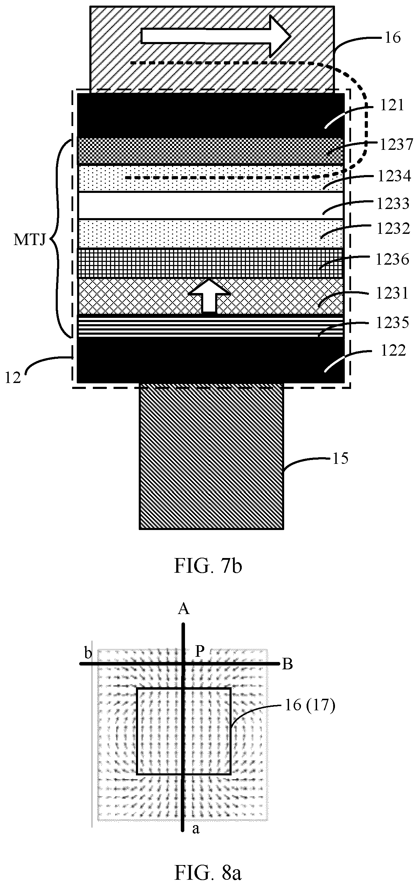

In a second implementation, as shown in FIG. 7a and FIG. 7b, the first magnetic structure 16 is in contact with the MTJ element 12, and a magnetization direction of the first magnetic structure 16 is perpendicular to a stacking direction of layers in the MTJ.

Herein, an example in which the stacking direction of the layers in the MTJ is a vertical direction is used, and the magnetization direction of the first magnetic structure 16 may be horizontal to left, or may be horizontal to right.

It should be understood that, when the magnetization direction of the first magnetic structure 16 is perpendicular to the stacking direction of the layers in the MTJ, as shown in FIG. 7a and FIG. 7b, the direction of the magnetic field generated by the first magnetic structure 16 at the free layer 1234 is perpendicular to the stacking direction of the layers in the MTJ.

It should be noted that, to ensure that the magnetization direction of the first magnetic structure 16 can still remain perpendicular to the stacking direction of the layers in the MTJ, and remain unchanged after an external magnetic field is removed, that is, to enable the first magnetic structure 16 to have magnetic shape anisotropy, a length of the first magnetic structure 16 along a direction perpendicular to the stacking direction of the layers in the MTJ is greater than or equal to a length of the first magnetic structure 16 along a direction parallel to the stacking direction of the layers in the MTJ. When the first magnetic structure 16 is a cylinder, a diameter of the first magnetic structure 16 is greater than or equal to a height of the first magnetic structure 16.

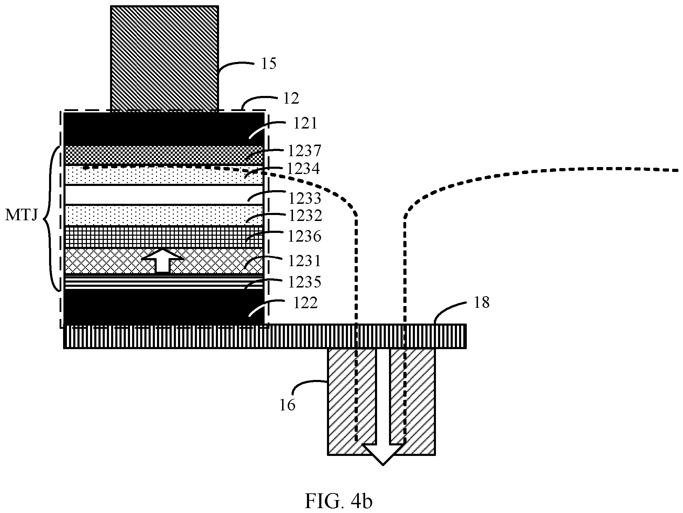

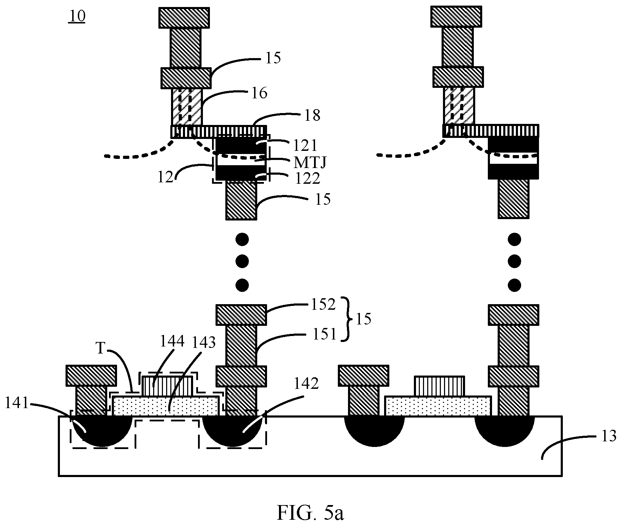

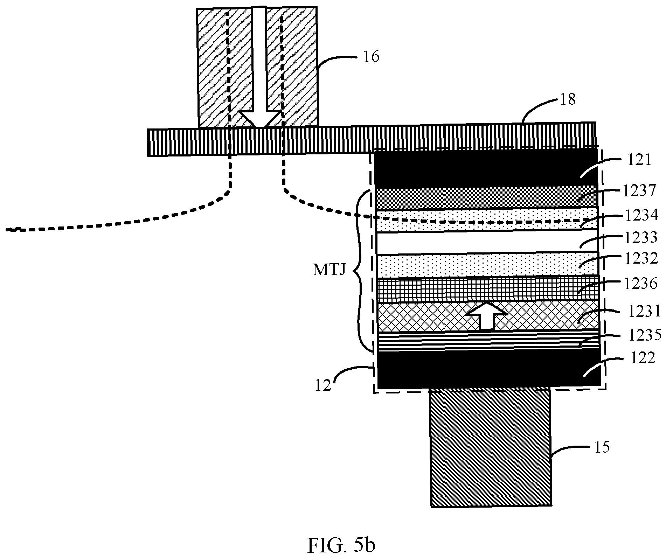

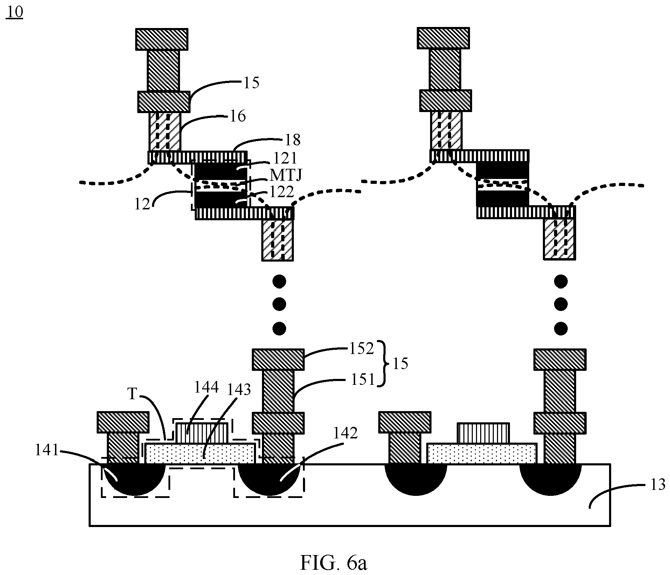

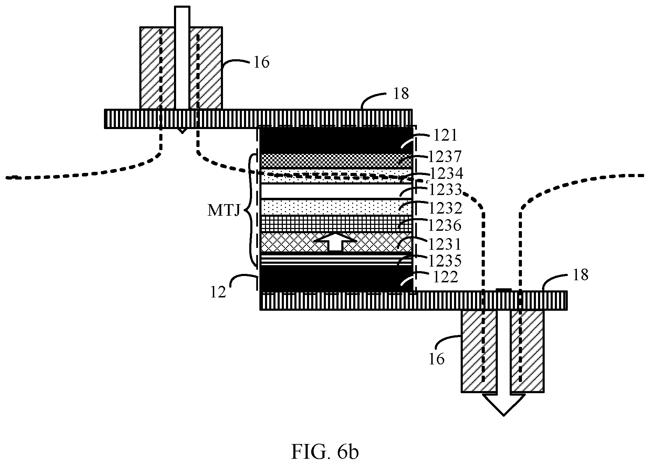

In addition, the memory 10 may include one first magnetic structure 16. In this case, as shown in FIG. 4a and FIG. 4b, the first magnetic structure 16 is connected between the MTJ element 12 and the source 141 or the drain 142 of the transistor T. When the memory 10 includes the connection layer 18, the first magnetic structure 16 is electrically connected to the MTJ element 12 through the connection layer 18. Alternatively, as shown in FIG. 5a and FIG. 5b, the first magnetic structure 16 is connected between the MTJ element 12 and the bit line BL. When the memory 10 includes the connection layer 18, the first magnetic structure 16 is electrically connected to the MTJ element 12 through the connection layer 18. The memory 10 may alternatively include two first magnetic structures 16. In this case, as shown in FIG. 6a and FIG. 6b, one first magnetic structure 16 is connected between the MTJ element 12 and the source 141 or the drain 142 of the transistor T, and the other first magnetic structure 16 is connected between the MTJ element 12 and the bit line BL. When the memory 10 includes the connection layer 18, the two first magnetic structures 16 are electrically connected to the MTJ element 12 through the two connection layers 18, and projections of the two first magnetic structures 16 on the connection layer 18 may have an overlapping region, or may not have an overlapping region. In FIG. 6a and FIG. 6b, an example in which the projections of the two first magnetic structures 16 on the connection layer 18 do not have an overlapping region is used for illustration.

In some embodiments, a material of the first magnetic structure 16 includes one or more of a cobalt monomer, an iron monomer, a nickel monomer, and an alloy including at least one of cobalt, iron, and nickel.

The alloy including at least one of cobalt, iron, and nickel may be, for example, a CoB (cobalt-boron) alloy or a FeB (iron-boron) alloy.

For example, a material of the connection layer 16 may be copper (Cu).

It may be understood that a material of a conductive structure 15 in the memory 10 is a non-magnetic material, for example, copper.

It should be noted that, dashed curves in FIG. 4a, FIG. 4b, FIG. 5a, FIG. 5b, FIG. 6a, FIG. 6b, FIG. 7a, and FIG. 7b represent magnetic lines of the first magnetic structure 16.

In some embodiments of this application, the first magnetic structure 16 may be formed by using a hole filling process. A specific process is as follows: First, an insulation layer is formed, where the insulation layer includes a via (via); next, a layer of magnetic thin film is deposited; and then, a magnetic thin film outside the via is smoothed, to form the first magnetic structure 16 in the via.

In addition, the conductive layer 15 in some of FIG. 4a, FIG. 5a, FIG. 6a, and FIG. 7a includes a first conductive part 151 and a second conductive part 152. Because when the conductive structure 15 is manufactured, the insulation layer is formed first, where the insulation layer includes the via; and next, the conductive thin film is formed, a part of the conductive thin film deposited in the via of the insulation layer is referred to as the first conductive part 151, the conductive thin film is patterned to form the foregoing conductive function pattern, and a part of the conductive thin film that is deposited above the via and that is formed through patterning is referred to as the second conductive part 152.

In addition, when the memory 10 includes a conductive structure 15 that is connected between the MTJ element 12 and the bit line BL and that is in contact with the MTJ element 12, the conductive structure 15 may be shown in FIG. 4a, and includes the first conductive part 151 and the second conductive part 152. For a specific manufacturing process, refer to the foregoing descriptions, and details are not described herein again.

When the memory 10 includes a conductive structure 15 that is connected between the MTJ element 12 and the source 141 or the drain 142 of the transistor T and that is in contact with the MTJ element 12, the conductive structure 15 may include the first conductive part 151 and the second conductive part. For a specific manufacturing process, refer to the foregoing descriptions. Details are not described herein again. As shown in FIG. 5a, the conductive structure 15 may alternatively include the first conductive part 151, but does not include the second conductive part 152. A specific manufacturing process is as follows: First, an insulation layer is formed, where the insulation layer includes a via; next, a conductive thin film is formed; and then, a conductive thin film outside the via is removed (for example, smoothed), and a part of the conductive thin film deposited in the via of the insulation layer forms the first conductive part 151, that is, the conductive structure 15.

As shown in FIG. 4a, when the memory 10 includes the first magnetic structure 16 connected between the MTJ element 12 and the source 141 or the drain 142 of the transistor T, after the first magnetic structure 16 is manufactured, a conductive thin film is formed, the conductive thin film is patterned to form the connection layer 18, and then the MTJ element 12 is formed.

As shown in FIG. 5a, when the memory 10 includes the first magnetic structure 16 connected between the MTJ element 12 and the bit line BL, after the MTJ element 12 is manufactured, the connection layer 18 is formed, and then the first magnetic structure 16 is formed. For a process of forming the connection layer 18, refer to the foregoing descriptions, and details are not described herein again. On this basis, after the first magnetic structure 16 is formed, a process of forming the conductive structure 15 may be as shown in FIG. 5a and FIG. 6a. The conductive thin film is formed, and the conductive thin film is patterned to form the conductive structure 15. Alternatively, the insulation layer may be formed first, where the insulation layer includes the via; and next, the conductive thin film is formed, the part of the conductive thin film deposited in the via of the insulation layer forms the first conductive part 151 of the conductive structure 15, the conductive thin film is patterned to form the foregoing conductive function pattern, and the part that is deposited above the via and that is formed through patterning of the conductive thin film is the second conductive part 152 of the conductive structure 15.

It should be understood that, when the direction of the magnetic field generated by the first magnetic structure 16 at the free layer 1234 is perpendicular to the magnetization direction of the free layer 1234, and when the free layer 1234 is reversed, the magnetic field generated by the first magnetic structure 16 at the free layer 1234 may apply a magnetic field force to the free layer 1234, which facilitates reversal of the free layer 1234. When the direction of the magnetic field generated by the first magnetic structure 16 at the free layer 1234 is not parallel to and is not perpendicular to the magnetization direction of the free layer 1234, and when the free layer 1234 is reversed, a magnetic field component (which may also be referred to as an in-plane component) of the magnetic field generated by the first magnetic structure 16 at the free layer 1234 in the direction perpendicular to the stacking direction of the layers in the MTJ, that is, a clear in-plane field generated by the first magnetic structure 16 at the free layer 1234, may apply a magnetic field force to the free layer 1234, which facilitates the reversal of the free layer 1234.

An embodiment of this application provides a memory 10. The memory 10 includes a plurality of memory cells 11 and bit lines BLs. The memory cell 11 includes a transistor T and an MTJ element 12 connected to the transistor T. The MTJ element 12 is disposed on a current transmission path between a source 141 or a drain 142 of the transistor T and the bit line BL. The MTJ element 12 includes a pinning layer 1231, a reference layer 1232, a tunneling layer 1233, and a free layer 1234 that are sequentially stacked. A magnetization direction of the pinning layer 1231 is parallel to a stacking direction of layers in the MTJ. The memory 10 further includes a first magnetic structure 16 disposed on the current transmission path. A direction of a magnetic field generated by the first magnetic structure 16 at the free layer 1234 is not parallel to a magnetization direction of the free layer 1234. Because the direction of the magnetic field generated by the first magnetic structure 16 at the free layer 1234 is not parallel to the magnetization direction of the free layer 1234, the magnetic field generated by the first magnetic structure 16 at the free layer 1234 may apply a magnetic field force to the free layer 1234, which facilitates reversal of the free layer 1234. In this way, a current required for the reversal of the free layer 1234 is reduced, incubation time (incubation time) of an STT is shortened, a reversal speed of the free layer 1234 is increased, write time is shortened, and write efficiency of the memory cell 11 is improved.

In some embodiments, the direction of the magnetic field generated by the first magnetic structure 16 at the free layer 1234 is perpendicular to the magnetization direction of the free layer 1234.

It should be understood that, when the first magnetic structure 16 is electrically connected to the MTJ element 12 through a connection layer 18, and a magnetization direction of the first magnetic structure 16 is parallel to the stacking direction of the layers in the MTJ, relative positions of the MTJ element 12 and the first magnetic structure 16 in a direction perpendicular to the stacking direction of the layers in the MTJ is adjusted, so that the direction of the magnetic field generated by the first magnetic structure 16 at the free layer 1234 is perpendicular to the magnetization direction of the free layer 1234. When the magnetization direction of the first magnetic structure 16 is parallel to the stacking direction of the layers in the MTJ, the magnetization direction of the first magnetic structure 16 may be the same as the magnetization direction of the pinning layer 1231, or may be opposite to the magnetization direction of the pinning layer 1231.

When the direction of the magnetic field generated by the first magnetic structure 16 at the free layer 1234 is perpendicular to the magnetization direction of the free layer 1234, the magnetic field generated by the first magnetic structure 16 at the free layer 1234 is larger, which further facilitates the reversal of the free layer 1234. Therefore, the current required for the reversal of the free layer 1234 can be further reduced, the incubation time of the STT is further shortened, and the reversal speed of the free layer 1234 is more effectively increased.

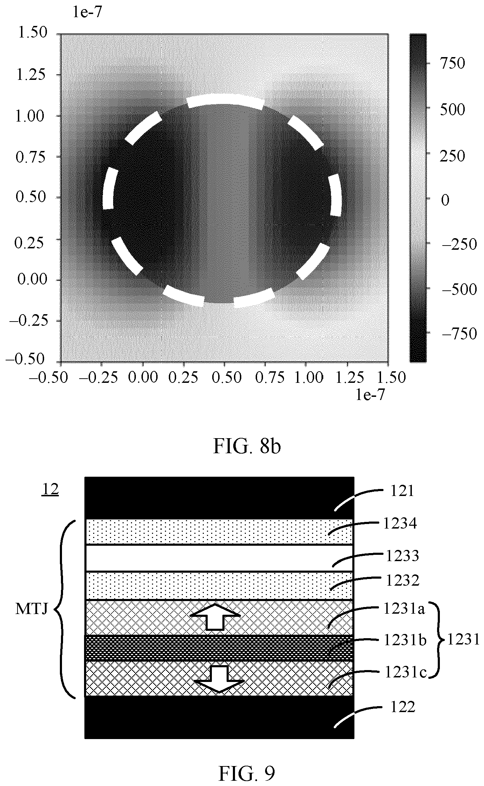

Refer to FIG. 8a and FIG. 8b. FIG. 8a is a schematic diagram of simulation. A block in FIG. 8a represents a first magnetic structure 16. A magnetization direction of the first magnetic structure 16 is parallel to a stacking direction of layers in an MTJ. FIG. 8a shows a direction of a magnetic field in the first magnetic structure 16 and a direction of a stray field generated externally. In FIG. 8a, an arrow represents a direction of a magnetic field of space in which the first magnetic structure 16 is located, and the direction of the magnetic field of the space in which the first magnetic structure 16 is located includes the direction of the magnetic field in the first magnetic structure 16 and the direction of the stray field generated externally. A black straight line A in FIG. 8a is parallel to the stacking direction of the layers in the MTJ. It can be learned from a position marked by using a black straight line B in FIG. 8a that, on a plane of the position marked by using the black straight line B, an in-plane stray field (to be specific, a stray field with a direction of a magnetic field perpendicular to the stacking direction of the layers in the MTJ) may be generated on two sides above the first magnetic structure 16. FIG. 8b is a simulation result diagram of a plane of the position marked by using the black straight line B in FIG. 8a, and a dashed circle in FIG. 8b represents an MTJ. It can be learned from FIG. 8b that, on the plane of the position marked by using the black straight line B in FIG. 8a, an in-plane stray field whose absolute value is about 300 Oe to 800 Oe is generated on two sides above a first magnetic structure 16, and a free layer 1234 may be reversed by using the stray field. In addition, by moving the MTJ (the dashed circle in FIG. 8b), a size of the in-plane stray field generated by the first magnetic structure 16 to which the MTJ is subject may be selected. To be specific, relative positions of the MTJ and the first magnetic structure 16 in a direction perpendicular to a stacking direction (for example, a horizontal direction) of layers in the MTJ may be adjusted to adjust the size of the in-plane stray field generated by the first magnetic structure 16 to which the MTJ is subject.

A current $J_{th}$ required for reversal of the free layer 1234 may be calculated according to the following formula:

$$J_{th} = \frac{2 e \alpha M_S t_F \left( H_{Keff} - 2\sqrt{H_X} \right)}{h \eta}$$

$H_X$ is an in-plane field generated by the first magnetic structure 16 at the free layer 1234 (to be specific, a direction of a magnetic field generated by the first magnetic structure 16 at the free layer 1234 is a magnetic field perpendicular to the stacking direction of the layers in the MTJ), $H_{K,eff}$ is an effective anisotropy field, $M_S$ is saturation magnetization, $t_F$ is a thickness of the free layer 1234, e is an electronic constant, $\alpha$ is a magnetic damping (magnetic damping) coefficient, h is a Planck constant, and $\eta$ is spin transfer efficiency.

It can be learned from the foregoing formula that the in-plane field generated by the first magnetic structure 16 at the free layer 1234 can significantly reduce a magnitude of the current required for the reversal of the free layer 1234. In addition, when the in-plane field acts on a magnetization direction of the free layer 1234, a thermal disturbance effect is enhanced, incubation time of an STT is shortened, the reversal of the free layer 1234 is accelerated, write duration of the MTJ is shortened, and dynamic write power consumption of the MTJ is further reduced.

On this basis, it is considered that a magnetic field generated by a pinning layer 1231 at the free layer 1234, in other words, a stray field generated by the pinning layer 1231 at the free layer 1234, causes the free layer 1234 to generate a large compensation field, and further may cause the current required for the reversal of the free layer 1234 to increase. Based on this, to avoid that the stray field generated by the pinning layer 1231 causes the current required for the reversal of the free layer 1234 to increase, the following provides two solutions as examples.

Manner 1: As shown in FIG. 9, the pinning layer 1231 includes a first pinning sub-layer 1231a, a non-magnetic layer 1231b, and a second pinning sub-layer 1231c that are sequentially stacked. A magnetization direction of the first pinning sub-layer 1231a is opposite to a magnetization direction of the second pinning sub-layer 1231c.

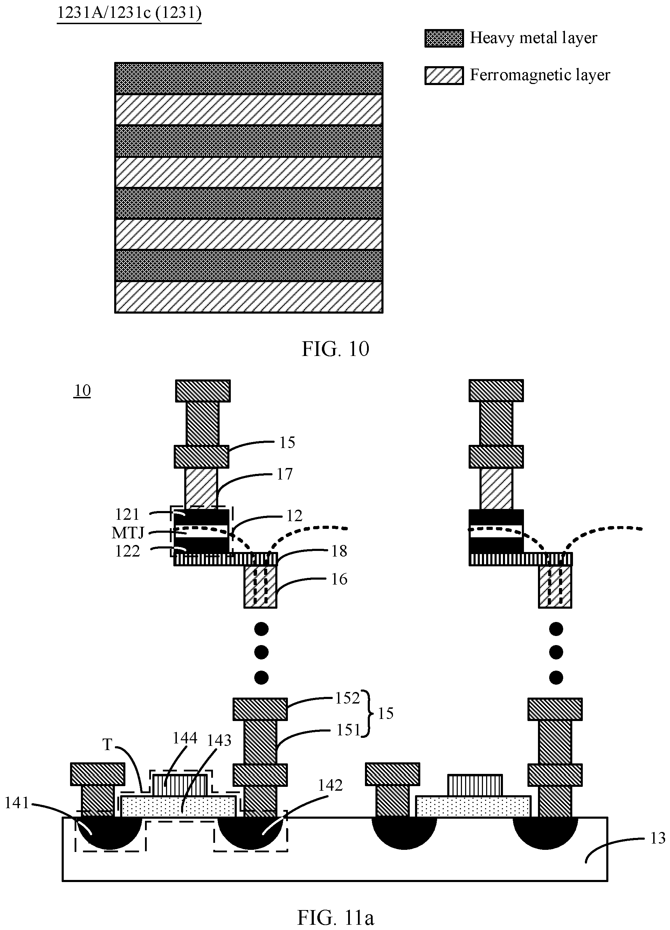

Herein, as shown in FIG. 10, both the first pinning sub-layer 1231a and the second pinning sub-layer 1231c include a ferromagnetic layer and a heavy metal layer that are alternately stacked along the stacking direction of the layers in the MTJ.

It should be noted that a quantity of ferromagnetic layers and heavy metal layers in the first pinning sub-layer 1231a is different from a quantity of ferromagnetic layers and heavy metal layers in the second pinning sub-layer 1231c. For example, the first pinning sub-layer 1231a includes a cobalt layer and a platinum layer that are alternately stacked along the stacking direction of the layers in the MTJ and that are represented as [Co/Pt]M. The second pinning sub-layer 1231c includes a cobalt layer and a platinum layer that are alternately stacked along the stacking direction of the layers in the MTJ and that are represented as [Co/Pt]N. M and N are both positive integers, and represent a quantity of cobalt layers or a quantity of platinum layers, where values of M and N are different.

In some embodiments, a material of the ferromagnetic layer includes one or more of a cobalt monomer, an iron monomer, a nickel monomer, and an alloy including at least one of cobalt, iron, and nickel.

In some embodiments, a material of the heavy metal layer includes one or more of a platinum (Pt) monomer, a tantalum monomer, a copper (Cu) monomer, an iridium (Ir) monomer, a ruthenium (Ru) monomer, a tungsten (W) monomer, and an alloy including at least one of platinum, tantalum, copper, iridium, ruthenium, and tungsten.

In some embodiments, a material of the non-magnetic layer 1231b includes one or more of a platinum monomer, a tantalum monomer, a copper monomer, an iridium monomer, a ruthenium monomer, a tungsten monomer, and an alloy including at least one of platinum, tantalum, copper, iridium, ruthenium, and tungsten.

It may be understood that if the first pinning sub-layer 1231a is close to a reference layer 1232 relative to the second pinning sub-layer 1231c, a magnetization direction of the reference layer 1232 is the same as the magnetization direction of the first pinning sub-layer 1231a. If the second pinning sub-layer 1231c is close to the reference layer 1232 relative to the first pinning sub-layer 1231a, the magnetization direction of the reference layer 1232 is the same as the magnetization direction of the second pinning sub-layer 1231c.

In this embodiment of this application, because the pinning layer 1231 includes the first pinning sub-layer 1231a and the second pinning sub-layer 1231c, and the magnetization direction of the first pinning sub-layer 1231a is opposite to the magnetization direction of the second pinning sub-layer 1231c, a direction of a stray field generated by the first pinning sub-layer 1231a at the free layer 1234 is opposite to a direction of a stray field generated by the second pinning sub-layer 1231c at the free layer 1234. Therefore, the stray field generated by the first pinning sub-layer 1231a at the free layer 1234 and the stray field generated by the second pinning sub-layer 1231c at the free layer 1234 can be offset, so that impact of a stray field generated by the pinning layer 1231 at the free layer 1234 on the reversal of the free layer 1234 can be reduced or eliminated, and the current required for the reversal of the free layer 1234 is further reduced.

In some embodiments, the stray field generated by the first pinning sub-layer 1231a at the free layer 1234 has a same size as the stray field generated by the second pinning sub-layer 1231c at the free layer 1234. In this way, the stray field generated by the first pinning sub-layer 1231a at the free layer 1234 and the stray field generated by the second pinning sub-layer 1231c at the free layer 1234 can be completely offset, so that the current required for the reversal of the free layer 1234 can be further reduced.

Manner 2:

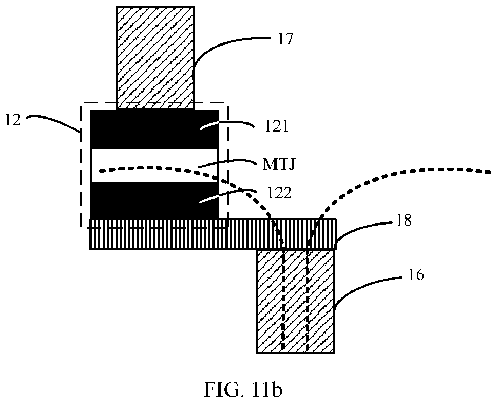

In some embodiments, as shown in FIG. 11a and FIG. 11b, a memory 10 further includes a second magnetic structure 17 that is disposed on a current transmission path and that is in contact with an MTJ element 12. An included angle between a magnetization direction of the second magnetic structure 17 and a magnetization direction of the pinning layer 1231 is (90°, 180°]. In other words, the included angle between the magnetization direction of the second magnetic structure 17 and the magnetization direction of the pinning layer 1231 is greater than 90° and less than or equal to 180°.

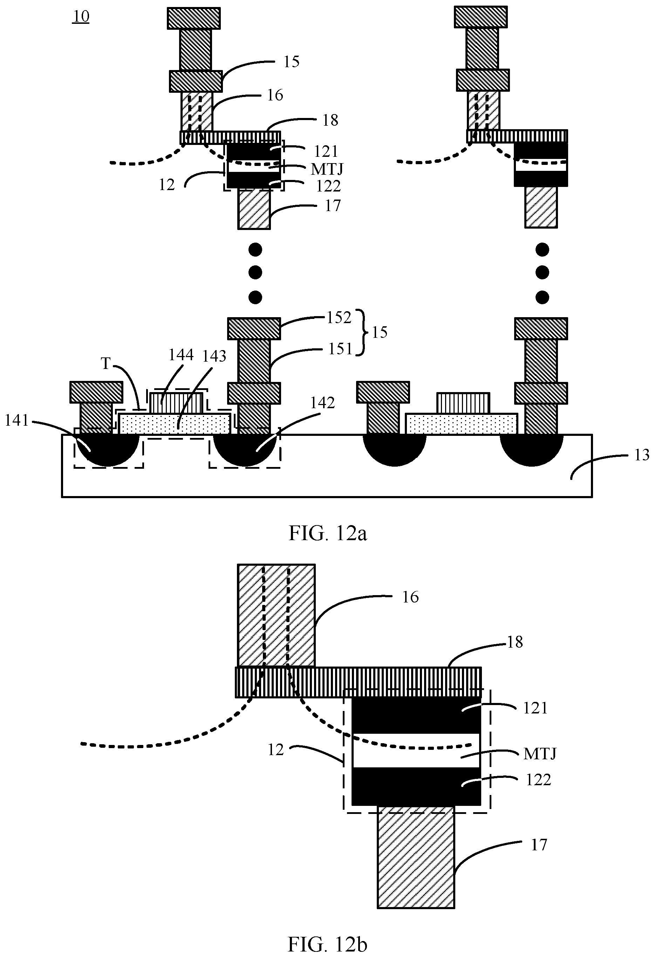

As shown in FIG. 11a and FIG. 11b, a first magnetic structure 16 is connected between the MTJ element 12 and a source 141 or a drain 142 of a transistor T, and the second magnetic structure 17 is connected between the MTJ element 12 and a bit line BL. Alternatively, as shown in FIG. 12a and FIG. 12b, the first magnetic structure 16 is connected between the MTJ element 12 and the bit line BL, and the second magnetic structure 17 is connected between the MTJ element 12 and the source 141 or the drain 142 of the transistor T.

Herein, a process of forming the second magnetic structure 17 may be the same as the foregoing process of forming the first magnetic structure 16. Refer to the foregoing descriptions. Details are not described herein again.

It should be understood that, because the second magnetic structure 17 is disposed on the current transmission path between the source 141 or the drain 142 of the transistor T and the bit line BL, the second magnetic structure 17 is conductive.

It may be understood that, because the included angle between the magnetization direction of the second magnetic structure 17 and the magnetization direction of the pinning layer 1231 is (90, 180°], an included angle between a direction of a magnetic field generated by the second magnetic structure 17 at the free layer 1234 and a direction of the magnetic field generated by the pinning layer 1231 at the free layer 1234 is (90, 180°].

In addition, when the included angle between the direction of the magnetic field generated by the second magnetic structure 17 at the free layer 1234 and the direction of the magnetic field generated by the pinning layer 1231 at the free layer 1234 is 180°, in other words, when the direction of the magnetic field generated by the second magnetic structure 17 at the free layer 1234 is opposite to the direction of the magnetic field generated by the pinning layer 1231 at the free layer 1234, the magnetic field generated by the second magnetic structure 17 at the free layer 1234 can offset the magnetic field generated by the pinning layer 1231 at the free layer 1234. Therefore, impact of the magnetic field generated by the pinning layer 1231 at the free layer 1234 on the free layer 1234 can be reduced. When the included angle between the direction of the magnetic field generated by the second magnetic structure 17 at the free layer 1234 and the direction of the magnetic field generated by the pinning layer 1231 at the free layer 1234 is (90°, 180°), in a direction opposite to the magnetization direction of the pinning layer 1231, the second magnetic structure 17 generates a magnetic field component at the free layer 1234. The magnetic field component that is generated by the second magnetic structure 17 at the free layer 1234 and that is in the direction opposite to the magnetization direction of the pinning layer 1231 may offset the magnetic field generated by the pinning layer 1231 at the free layer 1234.

In this embodiment of this application, because the included angle between the magnetization direction of the second magnetic structure 17 and the magnetization direction of the pinning layer 1231 is (90°, 180°], the magnetic field generated by the second magnetic structure 17 at the free layer 1234 can offset the magnetic field generated by the pinning layer 1231 at the free layer 1234, so that a compensation field generated by the free layer 1234 can be reduced or eliminated. In this way, the current required for the reversal of the free layer 1234 is reduced, and a problem of MTJ reversal asymmetry (to be specific, values of currents required when the magnetization direction of the free layer 1234 changes to two opposite directions are different) can be resolved. In addition, because the magnetic field generated by the pinning layer 1231 at the free layer 1234 may be offset by the magnetic field generated by the second magnetic structure 17 at the free layer 1234, a difference brought by impact of a stray field on the free layer 1234 does not need to be overcome by increasing the current. In this way, the magnetization direction of the free layer 1234 can be reversed by using a small current, so that power can be reduced, durability of the MTJ can be improved, and life of the MTJ can be prolonged.

In some examples, the magnetization direction of the second magnetic structure 17 is opposite to the magnetization direction of the pinning layer 1231, and the magnetic field generated by the second magnetic structure 17 at the free layer 1234 is the same as the magnetic field generated by the pinning layer 1231 at the free layer 1234.

When the magnetization direction of the second magnetic structure 17 is opposite to the magnetization direction of the pinning layer 1231, and the magnetic field generated by the second magnetic structure 17 at the free layer 1234 is the same as the magnetic field generated by the pinning layer 1231 at the free layer 1234, the magnetic field generated by the second magnetic structure 17 at the free layer 1234 can offset the magnetic field generated by the pinning layer 1231 at the free layer 1234. Therefore, a magnetic field received by the free layer 1234 is zero or approaches zero, a compensation field generated by the free layer 1234 due to the magnetic field is zero or approaches zero. In this way, the current required for the reversal of the free layer 1234 is further reduced, and the problem of MTJ reversal asymmetry is more effectively resolved.

It is considered that a reference layer 1232 may also generate a stray field at the free layer 1234. To prevent the stray field generated by the reference layer 1232 at the free layer 1234 from increasing the current required for the reversal of the free layer 1234, in some examples, the magnetization direction of the second magnetic structure 17 is opposite to the magnetization direction of the pinning layer 1231. In addition, the magnetic field generated by the second magnetic structure 17 at the free layer 1234 has a same magnitude as magnetic fields generated by the pinning layer 1231 and the reference layer 1232 at the free layer 1234. In this way, the magnetic fields generated by the pinning layer 1231 and the reference layer 1232 at the free layer 1234 can be offset by the magnetic field generated by the second magnetic structure 17 at the free layer 1234, to further reduce the current required for the reversal of the free layer 1234.

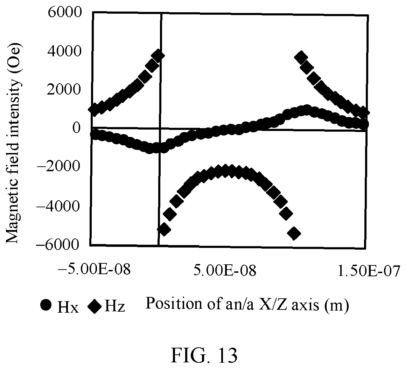

Refer to FIG. 8a. A block in FIG. 8a represents a second magnetic structure 17. A magnetization direction of the second magnetic structure 17 is parallel to a stacking direction of layers in an MTJ. It can be learned from a position marked by using a black straight line A in FIG. 8a that a direction of a magnetic field in the second magnetic structure 17 is opposite to a direction of a stray field generated externally. FIG. 13 is a simulation result diagram of positions marked by using the black straight line A (namely, a Z axis) and the black straight line B (namely, an X axis) in FIG. 8a. A horizontal coordinate represents a position of the X axis or the Z axis. A point a in FIG. 8a represents that a position of the Z axis is -5.00E-08, and a point b in FIG. 8a represents that a position of the X axis is -5.00E-08. A vertical coordinate in FIG. 13 represents a magnetic field (magnetic field) intensity, and a unit is Oe. Change of a magnetic field intensity Hx along an X-axis direction and change of a magnetic field intensity Hz along a Z-axis direction can be learned from FIG. 13. For example, an MTJ is located above a second magnetic structure 17. A position P in FIG. 8a represents a position of a free layer 1234, and the free layer 1234 is at a position of 20 nm on the Z axis. It can be learned from a simulation result provided in FIG. 13 that the second magnetic structure 17 generates a stray field of approximately 900 Oe to 2000 Oe at the position P, and a direction of the stray field is opposite to a direction of a magnetic field in the second magnetic structure 17. Based on this, the stray field generated by the second magnetic structure 17 may be used to offset a stray field generated by a pinning layer 1231.

On this basis, based on Manner 2, to reduce a thickness of the pinning layer 1231 and a thickness of the MTJ, in some embodiments, as shown in FIG. 10, the pinning layer 1231 includes a ferromagnetic layer and a heavy metal layer that are alternately stacked along a stacking direction of layers in the MTJ.

For example, the pinning layer 1231 includes a cobalt layer and a platinum layer ([Co/Pt]n, where n is a positive integer, and represents a quantity of cobalt layers or a quantity of platinum layers) that are alternately stacked along the stacking direction of the layers in the MTJ.

It should be noted that for materials of the ferromagnetic layer and the heavy metal layer, refer to the foregoing descriptions. Details are not described herein again.

Because the pinning layer 1231 includes only the ferromagnetic layer and the heavy metal layer that are alternately stacked along the stacking direction of the layers in the MTJ, the thickness of the pinning layer 1231 is greatly reduced, and a structure is simplified. This helps reduce roughness of an interface between a tunneling layer 1233 and the free layer 1234, reduce stress accumulation, and facilitate MTJ microshrinkage. In addition, the thickness of the pinning layer 1231 is greatly reduced, to be specific, a thickness of a conductive material under the tunneling layer 1233 is reduced, so that a probability of short circuit caused by resputtering during etching is reduced, and an engineering yield is increased.

In some other embodiments, a material of the pinning layer 1231 is a perpendicular magnetic anisotropy material.

For example, the material of the pinning layer 1231 includes one or more of an iron-platinum (FePt) alloy and a cobalt-platinum (CoPt) alloy.

Because the material of the pinning layer 1231 is the perpendicular magnetic anisotropy material, a magnetization direction of the pinning layer 1231 is easily magnetized to be parallel to the stacking direction of the layers in the MTJ. Therefore, the thickness of the pinning layer 1231 may be set to be small. In this way, the structure is simplified. This helps reduce the roughness of the interface between the tunneling layer 1233 and the free layer 1234, reduce the stress accumulation, and facilitate the MTJ micro shrinkage. In addition, the thickness of the pinning layer 1231 is greatly reduced, to be specific, the thickness of the conductive material under the tunneling layer 1233 is reduced, so that the probability of short circuit caused by resputtering during etching is reduced, and the engineering yield is increased.

It should be noted that FIG. 4a, FIG. 4b, FIG. 5a, FIG. 5b, FIG. 6a, FIG. 6b, FIG. 7a, FIG. 7b, FIG. 11a, FIG. 11b, FIG. 12a, and FIG. 12b in the specification of this application show only a connection relationship and a position relationship between the MTJ element 12 and the first magnetic structure 16 or the second magnetic structure 17, and do not limit a size relationship between the MTJ element 12 and the first magnetic structure 16 or the second magnetic structure 17. In the direction perpendicular to the stacking direction of the layers in the MTJ, a size of the first magnetic structure 16 or the second magnetic structure 17 may be greater than, equal to, or less than a size of the MTJ element 12.

Based on this, an embodiment of this application further provides an electronic device. The electronic device includes a circuit board and a memory connected to the circuit board. The memory may be any memory provided above. The circuit board may be a printed circuit board (printed circuit board, PCB). Certainly, the circuit board may alternatively be a flexible circuit board (flexible printed circuit board, FPC), or the like. The circuit board is not limited in this embodiment.

Optionally, the electronic device is different types of user equipment or a terminal device such as a computer, a mobile phone, a tablet computer, a wearable device, and a vehicle-mounted device. Alternatively, the electronic device may be a network device such as a base station. Optionally, the electronic device further includes a package substrate. The package substrate is fixed on a printed circuit board PCB through a solder ball, and the memory is fixed on the package substrate through the solder ball. It should be noted that, for related descriptions of the memory in the electronic device, refer to the descriptions of the memory in the foregoing embodiments. Details are not described in this embodiment of this application again.

On this basis, an embodiment of this application further provides a non-transitory computer-readable storage medium used together with a computer. The computer has software for creating an integrated circuit. The computer-readable storage medium stores one or more computer-readable data structures. The one or more computer-readable data structures have photomask data for manufacturing the memory provided in any one of the foregoing figures.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A memory, comprising a plurality of memory cells and bit lines that are disposed in a storage region of the memory and that are distributed in an array, wherein the memory cell comprises a transistor and a magnetic tunnel junction MTJ element connected to the transistor;

   the MTJ element is disposed on a current transmission path between a source or a drain of the transistor and the bit line, the MTJ element comprises a pinning layer, a reference layer, a tunneling layer, and a free layer that are sequentially stacked, and a magnetization direction of the pinning layer is parallel to a stacking direction of layers in an MTJ;
   the memory further comprises a first magnetic structure disposed on the current transmission path; and
   a direction of a magnetic field generated by the first magnetic structure at the free layer is not parallel to a magnetization direction of the free layer.

2. The memory according to claim 1, wherein the direction of the magnetic field generated by the first magnetic structure at the free layer is perpendicular to the magnetization direction of the free layer.

3. The memory according to claim 1 or 2, wherein the memory further comprises a connection layer disposed between the first magnetic structure and the MTJ element, and the first magnetic structure is electrically connected to the MTJ element through the connection layer; and
   a projection of the MTJ element on the connection layer and a projection of the first magnetic structure on the connection layer do not overlap in at least a partial region.

4. The memory according to any one of claims 1 to 3, wherein the first magnetic structure is connected between the MTJ element and the source or the drain of the transistor.

5. The memory according to any one of claims 1 to 4, wherein the first magnetic structure is connected between the MTJ element and the bit line.

6. The memory according to any one of claims 1 to 5, wherein the MTJ element further comprises a first electrode and a second electrode;

   the first electrode is located on a side of the free layer away from the pinning layer, and the second electrode is located on a side of the pinning layer away from the free layer; and
   the first electrode is electrically connected to the bit line, and the second electrode is electrically connected to the source or the drain of the transistor; or the first electrode is electrically connected to the source or the drain of the transistor, and the second electrode is electrically connected to the bit line.

7. The memory according to any one of claims 1 to 6, wherein a material of the first magnetic structure comprises one or more of a cobalt monomer, an iron monomer, a nickel monomer, and an alloy comprising at least one of cobalt, iron, and nickel.

8. The memory according to any one of claims 1 to 7, wherein the pinning layer comprises a first pinning sub-layer, a non-magnetic layer, and a second pinning sub-layer that are sequentially stacked; and a magnetization direction of the first pinning sub-layer is opposite to a magnetization direction of the second pinning sub-layer.

9. The memory according to claim 8, wherein both the first pinning sub-layer and the second pinning sub-layer comprise a ferromagnetic layer and a heavy metal layer that are alternately stacked along the stacking direction of the layers in the MTJ.

10. The memory according to claim 9, wherein a material of the ferromagnetic layer comprises one or more of a cobalt monomer, an iron monomer, a nickel monomer, and an alloy comprising at least one of cobalt, iron, and nickel; and a material of the heavy metal layer comprises one or more of a platinum monomer, a tantalum monomer, a copper monomer, an iridium monomer, a ruthenium monomer, a tungsten monomer, and an alloy comprising at least one of platinum, tantalum, copper, iridium, ruthenium, and tungsten.

11. The memory according to any one of claims 1 to 3, wherein the memory further comprises a second magnetic structure that is disposed on the current transmission path and that is in contact with the MTJ element, and an included angle between a magnetization direction of the second magnetic structure and the magnetization direction of the pinning layer is (90°, 180°]; and the first magnetic structure is connected between the MTJ element and the source or the drain of the transistor, and the second magnetic structure is connected between the MTJ element and the bit line; or the first magnetic structure is connected between the MTJ element and the bit line, and the second magnetic structure is connected between the MTJ element and the source or the drain of the transistor.

12. The memory according to claim 11, wherein the magnetization direction of the second magnetic structure is opposite to the magnetization direction of the pinning layer, and a magnetic field generated by the second magnetic structure at the free layer is the same as a magnetic field generated by the pinning layer at the free layer.

13. The memory according to claim 11 or 12, wherein the pinning layer comprises a ferromagnetic layer and a heavy metal layer that are alternately stacked along the stacking direction of the layers in the MTJ.

14. The memory according to claim 11 or 12, wherein a material of the pinning layer is a perpendicular magnetic anisotropy material.

15. The memory according to claim 14, wherein the material of the pinning layer comprises one or more of an iron-platinum alloy and a cobalt-platinum alloy.

16. The memory according to any one of claims 1 to 15, wherein materials of the reference layer and the free layer comprise a cobalt-iron-boron CoFeB alloy; and a material of the tunneling layer comprises magnesium oxide MgO.

17. The memory according to claim 1, wherein a gate of the transistor is connected to a word line control circuit by using a word line WL, the source or the drain of the transistor is connected to a data line, and the bit line BL is connected to a bit line control circuit.

18. An electronic device, comprising a circuit board and a memory electrically connected to the circuit board, wherein the memory is the memory according to any one of claims 1 to 17.

CPU

Cache

Storage
apparatus

FIG. 1a

CPU

Cache

Controller

Storage
apparatus

FIG. 1b

FIG. 1c

10

SL1　　11　12 BL1 SL2　　　　BL2 SLn–1　　　BLn–1 SLn　　　　BLn

WL1

T

WL2

WL3

WLn–1

WLn

FIG. 2

12

121
1234
1233
MTJ
1232
1231
122

FIG. 3a

12

121

1237

1234

1233

1232

1236

1231

1235

122

MTJ

FIG. 3b

10

152
15
151

121
MTJ
122

12

18

16

152
15
151

142

T
144 143

141

13

FIG. 4a

FIG. 4b

FIG. 5a

FIG. 5b

FIG. 6a

FIG. 6b

FIG. 7a

16
121
1237
1234
1233
1232
1236
1231
1235
122
15
MTJ
12

FIG. 7b

A
b
P
B
16 (17)
a

FIG. 8a

FIG. 8b

FIG. 9

1231A/1231c (1231)

Heavy metal layer

Ferromagnetic layer

FIG. 10

FIG. 11a

17

12

121

MTJ

122

18

16

FIG. 11b

FIG. 12a

FIG. 12b

FIG. 13

# EP 4 243 099 A1

## INTERNATIONAL SEARCH REPORT

International application No.

**PCT/CN2020/132932**

### A. CLASSIFICATION OF SUBJECT MATTER

H01L 43/08(2006.01)i; H01L 43/02(2006.01)i

According to International Patent Classification (IPC) or to both national classification and IPC

### B. FIELDS SEARCHED

Minimum documentation searched (classification system followed by classification symbols)

H01L

Documentation searched other than minimum documentation to the extent that such documents are included in the fields searched

Electronic data base consulted during the international search (name of data base and, where practicable, search terms used)

WPI, EPODOC, CNPAT, CNKI, IEEE: 存储器, 磁, 磁场, 磁化, 阵列, 位线, 隧道, 磁隧道结, 钉扎层, 隧穿层, 自由层, 堆叠, 方向, memory, magnet+, array, bit line, tunnel+, junction, MTJ, pinned layer, tunnel layer, free layer, stack, direction

### C. DOCUMENTS CONSIDERED TO BE RELEVANT

| Category* | Citation of document, with indication, where appropriate, of the relevant passages | Relevant to claim No. |
|---|---|---|
| A | CN 110970552 A (TAIWAN SEMICONDUCTOR MANUFACTURING COMPANY LIMITED) 07 April 2020 (2020-04-07) description, paragraphs [0019]-[0034], and figures 1-7 | 1-18 |
| A | CN 110192288 A (INTEL CORPORATION) 30 August 2019 (2019-08-30) entire document | 1-18 |
| A | CN 104362165 A (BEIHANG UNIVERSITY) 18 February 2015 (2015-02-18) entire document | 1-18 |
| A | US 9590010 B1 (QUALCOMM INC.) 07 March 2017 (2017-03-07) entire document | 1-18 |

☐ Further documents are listed in the continuation of Box C.   ☑ See patent family annex.

| | | |
|---|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family | |

| Date of the actual completion of the international search | Date of mailing of the international search report |
|---|---|
| **18 August 2021** | **26 August 2021** |

| Name and mailing address of the ISA/CN | Authorized officer |
|---|---|
| **China National Intellectual Property Administration (ISA/CN)**<br>**No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

33

**EP 4 243 099 A1**

**INTERNATIONAL SEARCH REPORT**
**Information on patent family members**

International application No.

**PCT/CN2020/132932**

| Patent document cited in search report | | | Publication date (day/month/year) | Patent family member(s) | | | Publication date (day/month/year) |
|---|---|---|---|---|---|---|---|
| CN | 110970552 | A | 07 April 2020 | TW | 202032782 | A | 01 September 2020 |
| | | | | DE | 102019114280 | A1 | 02 April 2020 |
| | | | | US | 2020105830 | A1 | 02 April 2020 |
| | | | | US | 2020303456 | A1 | 24 September 2020 |
| | | | | US | 10700125 | B2 | 30 June 2020 |
| | | | | KR | 20200037074 | A | 08 April 2020 |
| CN | 110192288 | A | 30 August 2019 | EP | 3563432 | A1 | 06 November 2019 |
| | | | | EP | 3563432 | A4 | 08 July 2020 |
| | | | | US | 2019280188 | A1 | 12 September 2019 |
| | | | | WO | 2018125085 | A1 | 05 July 2018 |
| CN | 104362165 | A | 18 February 2015 | CN | 104362165 | B | 16 June 2017 |
| US | 9590010 | B1 | 07 March 2017 | | None | | |

Form PCT/ISA/210 (patent family annex) (January 2015)

34